# EUROPÄISCHE PATENTSCHRIFT

(11) **EP 3 014 753 B1**
(45) Veröffentlichungstag und Bekanntmachung des Hinweises auf die Patenterteilung: **22.02.2023**
(21) Anmeldenummer: 14733200.1
(22) Anmeldetag: 27.06.2014
(51) Int. Cl.: H02M 7/00, G01R 15/18, G01R 31/52

(54) **STROMRICHTER**
POWER CONVERTER
CONVERTISSEUR

(30) Priorität: 28.06.2013 DE 102013212764
(43) Veröffentlichungstag der Anmeldung: 04.05.2016
(73) Patentinhaber: Schmidhauser AG, 8590 Romanshorn (CH)
(72) Erfinder: BURGERMEISTER, Andreas, CH-8576 Mauren (CH)
(74) Vertreter: Patentanwälte Ruff, Wilhelm, Beier, Dauster & Partner mbB
(86) Internationale Anmeldenummer: PCT/EP2014/063684
(87) Internationale Veröffentlichungsnummer: WO 2014/207195

(56) Entgegenhaltungen:
- EP-A1- 2 568 560
- EP-B1- 1 909 368
- WO-A1-2011/018530
- WO-A1-2011/018530
- DE-A1- 19 958 938
- DE-A1- 19 958 938
- DE-A1-102013 223 095
- FR-A1- 2 980 581
- FR-A1- 2 980 581
- US-A- 6 118 270
- US-A- 6 118 270
- US-A1- 2011 050 154
- US-A1- 2011 058 391
- US-A1- 2011 058 391
- US-A1- 2011 234 126
- US-A1- 2012 074 929
- US-A1- 2012 074 929
- Schneider: "Directional Fault Passage Indicators for MV underground networks - Manual", , 30 September 2004 (2004-09-30), XP055769863, Retrieved from the Internet: URL:https://manualzilla.com/doc/6364774/fl air-310-flair-370---engineering-site [retrieved on 2021-01-28]
- Schneider Electric: "Flair 279 user manual", , 31 July 2008 (2008-07-31), XP055769845, Retrieved from the Internet: URL:https://www.se.com/us/en/download/docu ment/D2160073/ [retrieved on 2021-01-28]

## Beschreibung

Die Erfindung betrifft einen Stromrichter, insbesondere in Form eines Wechselrichters oder eines Frequenzumrichters.

Bei Stromrichtern besteht häufig die Notwendigkeit, einen Erdschluss und/oder Kurzschluss an einem oder mehreren Anschlüssen zu detektieren, um bei detektiertem Erdschluss bzw. Kurzschluss einen sicheren Zustand herbeizuführen, beispielsweise eine Spannungs- oder Stromausgabe an dem entsprechenden Anschluss zu unterbrechen.

Die US 2011/0058391 A1 zeigt einen Stromrichter mit drei gleichartigen Stromsensoren.

Die DE 199 58 938 A1 zeigt ein Verfahren und eine Messeinrichtung zur Überwachung eines Stroms in einem elektrischen Leiter mit einer Spule zur Messung des Leiterstroms.

Die US 6,118,270 A zeigt eine Spule zur Strommessung.

Die WO 2011/018530 A1 zeigt einen Stromsensor in Form einer Spule.

Die FR 2 980 581 A1 zeigt eine Spule zur Strommessung.

Die US 2012/0074929 A1 zeigt eine Spule zur Strommessung.

Die US 2011/0234126 A1 zeigt einen Stromrichter mit einer Erdschluss- und Kurzschlusserkennungsschaltung, die einen Summenstromsensor aufweist, der zur Erdschluss- und Kurzschlusserkennung einen Summenstrom über alle Phasenleiter misst.

Die Veröffentlichung Schneider: "Directional Fault Passage Indicators for MV underground networks - Manual", 30. September 2004 (2004-09-30), XP055769863 zeigt ein Messgerät zur richtungsgebundenen Erdfehlermessung unterirdischer Stromnetze.

Die EP 1 909 368 A2 zeigt eine Schaltungsanordnung und ein Verfahren zur Isolationsüberwachung für Umrichteranwendungen.

Der Erfindung liegt die Aufgabe zugrunde, einen Stromrichter mit einer einfach zu implementierenden, kostengünstigen und/oder platzsparenden Erd- und Kurzschlusserkennung zur Verfügung zu stellen.

Die Erfindung löst diese Aufgabe durch einen Stromrichter nach Anspruch 1. Ausgestaltungen der Erfindung sind Gegenstand der Unteransprüche.

Der Stromrichter, insbesondere ein Stromrichter in Form eines Wechselrichters oder Frequenzumrichters, dient zum Ansteuern eines herkömmlichen dreiphasigen Drehstrommotors, der beispielsweise pro Phase einen Phasenleiter bzw. Phasenanschluss aufweist. Ein jeweiliger Phasenleiter kann einen so genannten Strang bilden. Im Übrigen sei insoweit auch auf die einschlägige Fachliteratur verwiesen.

Unter einem Stromrichter wird eine Vorrichtung zum Umwandeln eines elektrischen Signals in ein anderes elektrisches Signal verstanden, wobei bei der Umwandlung beispielsweise eine Signalamplitude und/oder eine Signalfrequenz umgewandelt wird. Diese Umwandlung erfolgt in der Regel mittels elektronischer Bauelemente, wie Transistoren, insbesondere in Form von IGBTs oder MOSFETs, Dioden oder Thyristoren. Im Übrigen sei insoweit auch auf die einschlägige Fachliteratur verwiesen.

Der Stromrichter weist einen ersten Anschluss zum Anschließen eines ersten Phasenleiters der drei Phasenleiter des Drehstrommotors bzw. des zugehörigen Anschlusses des Drehstrommotors auf, wobei ein über den ersten Anschluss auszugebender bzw. ausgegebener Strom mittels einer elektrischen Zuleitung, beispielsweise in Form eines elektrisch leitenden Kabels oder einer Leiterbahn einer Leiterplatte, innerhalb des Stromrichters zum ersten Anschluss geführt ist.

Der Stromrichter weist weiter eine Erdschluss- und Kurzschlusserkennungsschaltung auf, die dazu ausgebildet ist, einen Erdschluss und einen Kurzschluss des ersten Anschlusses zu detektieren.

Die Erdschluss- und Kurzschlusserkennungsschaltung weist eine Spule mit einer Wicklung auf. Die Wicklung ist bevorzugt derart benachbart zu der elektrischen Zuleitung angeordnet bzw. positioniert, dass eine Stromänderung in der elektrischen Zuleitung eine mit herkömmlichen Bauelementen messbare Spannung in der Spule bzw. deren Wicklung induziert. Die Wicklung ist derart angeordnet, dass sie abweichend vom Prinzip eines herkömmlichen Stromwandlers die elektrische Zuleitung nicht räumlich umschließt bzw. nicht räumlich umfasst. Mit anderen Worten durchdringt die elektrische Zuleitung die Wicklung nicht, wie dies bei einem herkömmlichen Stromwandler der Fall ist. Weiter ist die Spule nicht elektrisch zwischen den ersten Anschluss und die elektrische Zuleitung eingeschleift. Auch ist bevorzugt dem ersten Anschluss kein Shunt-Widerstand zur Strommessung zugeordnet.

Die Erdschluss- und Kurzschlusserkennungsschaltung weist weiter eine Auswerteeinrichtung auf, die dazu ausgebildet ist, eine in der Wicklung induzierte Spannung zur Erdschluss- und Kurzschlusserkennung auszuwerten. Die Auswerteeinrichtung kann beispielsweise eine Auswerteelektronik aufweisen oder als Auswerteelektronik verkörpert sein, die ein Signal erzeugt, sobald die induzierte Spannung einen vorgebbaren bzw. vorgegebenen Schwellenwert überschreitet. d.h. eine Stromänderung, bevorzugt ein Stromanstieg, in der elektrischen Zuleitung ein vorgebbares Maß überschreitet.

Der Stromrichter weist einen zweiten Anschluss zum Anschließen eines zweiten der drei Phasenleiter bzw. des zugehörigen Anschlusses des Drehstrommotors und einen dritten Anschluss zum Anschließen eines dritten der drei Phasenleiter bzw. des zugehörigen Anschlusses des Drehstrommotors auf.

Weiter weist der Stromrichter einen ersten Stromsensor, beispielsweise in Form eines herkömmlichen Stromwandlers oder eines Shunt-Widerstands, auf, der dazu ausgebildet ist, einen am zweiten Anschluss ausgegebenen Strom zu messen.

Weiter weist der Stromrichter einen zweiten Stromsensor, beispielsweise in Form eines herkömmlichen Stromwandlers oder eines Shunt-Widerstands, auf, der dazu ausgebildet ist, einen am dritten Anschluss ausgegebenen Strom zu messen.

Der Stromrichter weist genau eine Erdschluss- und Kurzschlusserkennungsschaltung und genau zwei Stromsensoren auf. Auf diese Weise kann am zweiten und dritten Anschluss mittels der herkömmlichen Stromsensoren eine herkömmliche Erdschluss- und Kurzschlusserkennung durchgeführt werden. Mittels der Erdschluss- und Kurzschlusserkennungsschaltung kann an dem ersten Anschluss im Vergleich zu einem herkömmlichen dedizierten Stromsensor sehr platzsparend und kostengünstig eine Erdschluss- und Kurzschlusserkennung durchgeführt werden, ohne dass hierfür ein herkömmliche Stromsensor beispielsweise in Form eines Stromwandlers vorzusehen ist.

Die Wicklung bzw. die Windungen kann/können durch mindestens eine wicklungsbildende Leiterbahn auf einer Leiterplatte gebildet sein. Die Wicklung bzw. die Windungen kann/können durch Leiterbahnen auf unterschiedlichen Lagen der Leiterplatte gebildet sein, wobei beispielsweise auf vier Lagen jeweils drei Windungen der Wicklung vorgesehen sein können, die beispielsweise mittels Durchkontaktierungen elektrisch miteinander verbunden sind, so dass eine Spule mit insgesamt zwölf Windungen entsteht.

Die elektrische Zuleitung kann ebenfalls als eine oder mehrere Leiterbahnen auf der Leiterplatte gebildet sein, wobei zur elektrischen Isolierung zwischen der elektrischen Zuleitung und der Wicklung die elektrische Zuleitung auf einer oder mehreren Lagen der Leiterplatte angeordnet sein kann, die von der oder den Lagen verschieden sind, auf denen die Leiterbahnen angeordnet sind, die die Wicklung der Spule bilden.

Die Spule kann aus mehreren elektrisch gekoppelten Teilspulen gebildet sein. Beispielsweise kann eine erste der Teilspulen auf einer ersten Seite der elektrischen Zuleitung angeordnet sein und eine zweite der Teilspulen kann auf einer zweiten, der ersten Seite gegenüberliegenden Seite der elektrischen Zuleitung angeordnet sein.

Die Erfindung wird nachfolgend unter Bezugnahme auf die Zeichnungen detailliert beschrieben. Hierbei zeigt schematisch:
- Fig. 1: einen Stromrichter in Form eins Frequenzumrichters zum Ansteuern eines Drehstrommotors und
- Fig. 2: ein Prinzipschaltbild einer Auswerteeinrichtung zur Erdschluss- und Kurzschlusserkennung des in Fig. 1 gezeigten Frequenzumrichters.

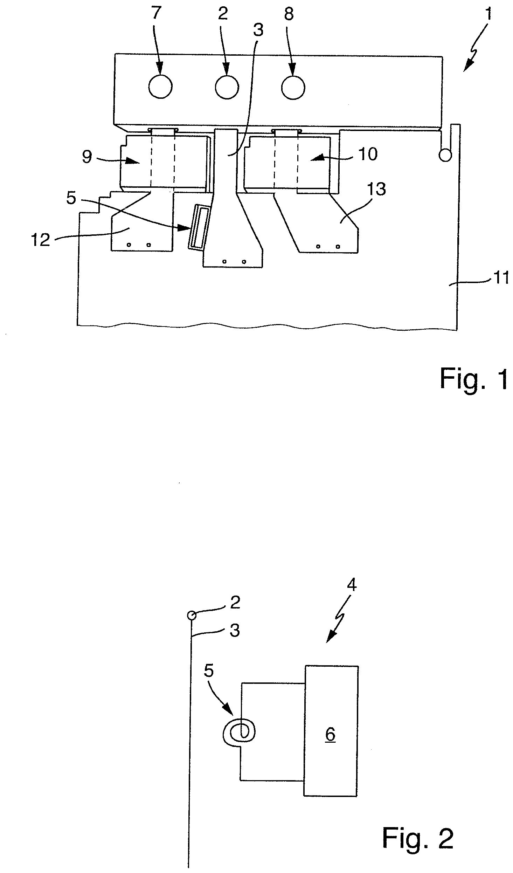

Fig. 1 zeigt einen Stromrichter in Form eines Frequenzumrichters 1 zum Ansteuern eines herkömmlichen, nicht gezeigten Drehstrommotors mit drei Phasenleitern bzw. drei Strängen.

Der Frequenzumrichter 1 weist herkömmlich drei Anschlüsse bzw. Ausgänge 2, 7 und 8 zum elektrischen Verbinden mit zugehörigen Phasenleitern bzw. Strängen des Drehstrommotors auf.

Ein über den ersten Anschluss 2 auszugebender Strom ist mittels einer elektrischen Zuleitung 3, die als Leiterbahn auf einer oder mehreren Lagen einer mehrlagigen Leiterplatte 11 gebildet ist, zum ersten Anschluss 2 geführt. Entsprechende Leiterbahnen 12 und 13 dienen als elektrische Zuleitungen zu den Anschlüssen 7 bzw. 8.

Ein erster Stromsensor in Form eines Stromwandlers 9 ist dazu ausgebildet, einen am zweiten Anschluss 7 ausgegebenen Strom zu messen.

Ein zweiter Stromsensor in Form eines Stromwandlers 10 ist dazu ausgebildet, einen am dritten Anschluss 8 ausgegebenen Strom zu messen.

Die Leiterplatte 11 weist im Bereich der Anschlüsse 2, 7 und 8 drei fingerförmige Vorsprünge auf, die zu den Anschlüssen 2, 7 bzw. 8 führen. Auf einer oder mehreren Lagen der fingerförmigen Vorsprünge der Leiterplatte 11 verlaufen die Leiterbahnen 3, 12 bzw. 13 jeweils flächig. Die fingerförmigen Vorsprünge der Leiterplatte 11, die den Leiterbahnen 12 und 13 zugeordnet sind, sind herkömmlich von den Stromwandlern 9 bzw. 10 umschlossen.

Die mittels der Stromwandler 9 und 10 gemessenen Ströme dienen unter anderem zur Erdschluss- und Kurzschlusserkennung an den Anschlüssen 7 bzw. 8. Die gemessenen Ströme können weiter auch zu einer Strom-/Spannungsregelung, Momentenregelung usw. dienen.

Eine Spule 5 ohne weichmagnetischen Kern mit einer Wicklung mit insgesamt zwölf Windungen ist unmittelbar seitlich benachbart zu der elektrischen Zuleitung bzw. Leiterbahn 3 angeordnet, wobei die Wicklung bzw. die Windungen die elektrische Zuleitung bzw. Leiterbahn 3 nicht umschließt/umschließen. Die Spule 5 bildet eine Induktionsschlaufe.

Die Windungen der Spule 5 sind durch eben spiralförmig verlaufende Leiterbahnen auf der Leiterplatte 11 gebildet, wobei jeweils drei spiralförmig verlaufende Leiterbahnen auf einer zugehörigen Lage der Leiterplatte 11 vorgesehen sind. Eine elektrische Kontaktierung zwischen den Leiterbahnen unterschiedlicher Lagen erfolgt mittels Durchkontaktierungen. Eine Wicklungsachse bzw. Windungsachse steht senkrecht zu einer durch die Leiterplatte 11 gebildeten Ebene.

Die Spule 5 ist Bestandteil einer Erdschluss- und Kurzschlusserkennungsschaltung 4, wie sie als Prinzipschaltbild in Fig. 2 dargestellt ist. Die Erdschluss- und Kurzschlusserkennungsschaltung 4 weist neben der Spule 5 eine Auswerteeinrichtung bzw. Auswerteelektronik 6 auf, die basierend auf einem Pegel einer in der Wicklung der Spule 5 induzierten Spannung einen Erdschluss- bzw. einen Kurzschluss detektiert.

Ein starker Stromanstieg bedingt durch einen Erd- bzw. einen Kurzschluss in der elektrischen Zuleitung 3 bewirkt einen hohen Pegel der induzierten Spannung, so dass beim Überschreiten eines entsprechend gewählten Schwellenwerts der induzierten Spannung ein Erd- bzw. Kurzschluss detektiert wird.

Mittels der Erfindung kann in einem Frequenzumrichter mit herkömmlicher Phasenstrommessung auf 2 Phasen ein durch Erdschluss verursachter Überstrom auch auf der dritten Phase, welche nicht mit einer herkömmlichen Strommessung versehen ist, erkannt und dann abgeschaltet werden.

Das Erkennen eines Erdschlusses oder Kurzschlusses einer Motorphase erfolgt mittels induktiver Kopplung auf einen Leiter, vorzugsweise in Form einer Spule mit einer oder mehreren Windungen, wobei die induzierte Spannung zur Kurzschluss- bzw. Erdschlusserkennung ausgewertet wird. Dies ist sowohl in Form eines separaten Bauteils oder in Form von Leiterbahnen mit einer oder mehreren Lagen möglich, wobei die Spule in der Nähe des zu messenden Stromleiters bzw. der entsprechenden elektrischen Zuleitung liegt.

Die Spule kann aus mehreren Einzelspulen, beispielsweise links und rechts der zu überwachenden elektrischen Zuleitung, aufgebaut sein. Nachgeschaltet ist eine Elektronik zur Auswertung der induzierten Spannung.

## Patentansprüche

1. Stromrichter (1) zum Ansteuern eines Drehstrommotors mit drei Phasenleitern, aufweisend:
- einen ersten Anschluss (2) zum Anschließen eines ersten der drei Phasenleiter des Drehstrommotors, wobei ein über den ersten Anschluss (2) auszugebender Strom mittels einer elektrischen Zuleitung (3) zum ersten Anschluss (2) geführt ist,
- einen zweiten Anschluss (7) zum Anschließen eines zweiten der drei Phasenleiter,
- einen dritten Anschluss (8) zum Anschließen eines dritten der drei Phasenleiter,
- einen ersten Stromsensor (9), der dazu ausgebildet ist, einen am zweiten Anschluss (7) ausgegebenen Strom zu messen, und
- einen zweiten Stromsensor (10), der dazu ausgebildet ist, einen am dritten Anschluss (8) ausgegebenen Strom zu messen,
**gekennzeichnet durch**
- eine Erdschluss- und Kurzschlusserkennungsschaltung (4), die dazu ausgebildet ist, einen Erdschluss und einen Kurzschluss des ersten Anschlusses (2) zu detektieren, aufweisend:
- eine Spule (5) ohne weichmagnetischen Kern mit einer Wicklung, die benachbart zu der elektrischen Zuleitung (3) angeordnet ist, wobei die Wicklung die elektrische Zuleitung nicht umschließt, und
- eine Auswerteeinrichtung (6), die dazu ausgebildet ist, eine in der Wicklung induzierte Spannung zur Erdschluss- und Kurzschlusserkennung auszuwerten,
- wobei der Stromrichter (1) genau eine Erdschluss- und Kurzschlusserkennungsschaltung (4) und genau zwei Stromsensoren (9, 10) aufweist.

2. Stromrichter nach Anspruch 1, **dadurch gekennzeichnet, dass**
- die Wicklung durch mindestens eine Leiterbahn einer Leiterplatte (11) gebildet ist.

3. Stromrichter nach Anspruch 2, **dadurch gekennzeichnet, dass**
- die Wicklung durch Leiterbahnen auf unterschiedlichen Lagen der Leiterplatte (11) gebildet ist.

4. Stromrichter nach Anspruch 2 oder 3, **dadurch gekennzeichnet, dass**
- die elektrische Zuleitung (3) als Leiterbahn der Leiterplatte gebildet ist.

5. Stromrichter nach einem der vorhergehenden Ansprüche, **dadurch gekennzeichnet, dass**
- die Spule aus mehreren Teilspulen gebildet ist.

6. Stromrichter nach Anspruch 5, **dadurch gekennzeichnet, dass**
- eine erste der Teilspulen auf einer ersten Seite der elektrischen Zuleitung angeordnet ist und eine zweite der Teilspulen auf einer zweiten, der ersten Seite gegenüberliegenden Seite der elektrischen Zuleitung angeordnet ist.

## Claims

1. Power converter (1) for driving a three-phase AC motor with three phase conductors, having:
- a first connection (2) for connecting a first of the three phase conductors of the three-phase AC motor, wherein a current which is to be output by means of the first connection (2) is routed to the first connection (2) by means of an electrical feed line (3),
- a second connection (7) for connecting a second of the three phase conductors,
- a third connection (8) for connecting a third of the three phase conductors,
- a first current sensor (9) which is designed to measure a current which is output at the second connection (7), and
- a second current sensor (10) which is designed to measure a current which is output at the third connection (8),
**characterized by**
- an earth-fault and short-circuit identification circuit (4) which is designed to detect an earth fault and a short circuit of the first connection (2), having:
- a coil (5), without a soft-magnetic core and with a winding, which is arranged adjacent to the electrical feed line (3), wherein the winding does not surround the electrical feed line, and
- an evaluation device (6) which is designed to evaluate a voltage, which is induced in the winding, for earth-fault and short-circuit identification,
- wherein the power converter (1) has precisely one earth-fault and short-circuit identification circuit (4) and precisely two current sensors (9, 10).

2. Power converter according to Claim 1, **characterized in that**
- the winding is formed by at least one conductor track of a printed circuit board (11).

3. Power converter according to Claim 2, **characterized in that**
- the winding is formed by conductor tracks on different layers of the printed circuit board (11).

4. Power converter according to Claim 2 or 3, **characterized in that**
- the electrical feed line (3) is formed as a conductor track of the printed circuit board.

5. Power converter according to one of the preceding claims, **characterized in that**
- the coil is formed from a plurality of coil elements.

6. Power converter according to Claim 5, **characterized in that**
- a first of the coil elements is arranged on a first side of the electrical feed line, and a second of the coil elements is arranged on a second side of the electrical feed line, said second side being situated opposite the first side.

## Revendications

1. Convertisseur statique (1) destiné à commander un moteur triphasé avec trois conducteurs de phase, comprenant :
- une première borne (2) servant au raccordement d'un premier des trois conducteurs de phase du moteur triphasé, un courant à délivrer par le biais de la première borne (2) étant acheminé à la première borne (2) au moyen d'une ligne d'amenée électrique (3),
- une deuxième borne (7) servant au raccordement d'un deuxième des trois conducteurs de phase,
- une troisième borne (8) servant au raccordement d'un troisième des trois conducteurs de phase,
- un premier capteur de courant (9), qui est configuré pour mesurer un courant délivré au niveau de la deuxième borne (7), et
- un deuxième capteur de courant (10), qui est configuré pour mesurer un courant délivré au niveau de la troisième borne (8),
**caractérisé par**
- un circuit de reconnaissance de court-circuit à la terre et de court-circuit (4), qui est configuré pour détecter un court-circuit à la terre et un court-circuit de la première borne (2), comprenant :
- une bobine (5) sans noyau magnétique tendre pourvue d'un enroulement, qui est disposé adjacent à la ligne d'amenée électrique (3), l'enroulement n'entourant pas la ligne d'amenée électrique, et
- un dispositif d'interprétation (6), qui est configuré pour interpréter une tension induite dans l'enroulement en vue de la reconnaissance de court-circuit à la terre et de court-circuit,
- le convertisseur statique (1) possédant exactement un circuit de reconnaissance de court-circuit à la terre et de court-circuit (4) et exactement deux capteurs de courant (9, 10).

2. Convertisseur statique selon la revendication 1, **caractérisé en ce que**
- l'enroulement est formé par au moins une piste conductrice d'un circuit imprimé (11).

3. Convertisseur statique selon la revendication 2, **caractérisé en ce que**
- l'enroulement est formé par des pistes conductrices sur des couches différentes du circuit imprimé (11).

4. Convertisseur statique selon la revendication 2 ou 3, **caractérisé en ce que**
- la ligne d'amenée électrique (3) est réalisée sous la forme d'une piste conductrice du circuit imprimé.

5. Convertisseur statique selon l'une des revendications précédentes, **caractérisé en ce que**
- la bobine est formée de plusieurs bobines partielles.

6. Convertisseur statique selon la revendication 5, **caractérisé en ce que**
- une première des bobines partielles est disposée sur un premier côté de la ligne d'amenée électrique et une deuxième des bobines partielles est disposée sur un deuxième côté, opposé au premier côté, de la ligne d'amenée électrique.
